# EUROPEAN PATENT APPLICATION

(11) **EP 2 378 852 A2**
(43) Date of publication of application: **19.10.2011**
(21) Application number: 11159695.3
(22) Date of filing: 25.03.2011
(51) Int. Cl.: H05K 13/00

(54) **A machine performance testing method and device**

(30) Priority: 15.04.2010 CN 201010150070
(71) Applicant: SIEMENS AKTIENGESELLSCHAFT, 80333 München (DE)
(72) Inventor: Galuschki, Klaus-Peter, 12487, Berlin (DE); Gong, Yi Hua, 200023, Shanghai (CN); Hu, Yu, 200433, Shanghai (CN); Shen, Ming, 201203, Shanghai (CN)

(57) **Abstract**

The present invention discloses a machine performance testing device, comprising a transparent panel, a scanning device, and a computing device; wherein the transparent panel is used to acquire a test sample from a machine to be tested; wherein the test sample comprises at least one object placed on the transparent panel by the machine to be tested; the scanning device is used to scan the transparent panel to obtain image data; and the computing device is used to determine the operation accuracy of the machine to be tested according to the image data from the scanning device. The present invention further discloses a corresponding machine performance testing method and a device for acquiring an image of the test sample.

## Description

### Technical field

The present invention relates to the technical field of electronic assembly and, particularly, to a machine performance testing method, a machine performance testing device and a device for acquiring an image of a test sample applied in the surface mount technology (SMT) industry.

### Background art

Surface mount technology (also known as SMT) is currently the most popular technology and process in the electronic assembly industry, and it is suitable for assembling electronic products with high density, small size, and light weight. In said technology, the size and weight of the SMT components are only about one tenth of that of the traditional plug-in mounting components, and after employing the surface mount technology, the size of the electronic products can generally be reduced by 40-60% and the weight thereof reduced by 60-80%.

In SMT, in order to ensure the accuracy of the machine operation, a very important aspect is to test the machine performance. For example, the performance of a piece of equipment, such as the positioning accuracy of a placement machine, a printer and the like needs to be tested; when testing a placement machine, it is necessary to measure the position accuracy when the placement machine places an assembly on a certain board; and when testing a printer, it is necessary to measure the position accuracy when the printer prints a solder paste or glue on a certain board.

Currently, there are two methods for testing the machine performance:
I. One method is by using a coordinate measurement machine (CMM). However, in SMT, a large amount of assemblies to be measured generally are distributed on a board with a relatively small area, and it is necessary for the coordinate measurement machine to measure each assembly one by one. However, in order to ensure the testing accuracy, such coordinate measurement machine cannot be moved at a high frequency, and in turn the measurement efficiency is too low. Moreover, such a measurement machine is very expensive.
II. The other method is to use a specific measurement machine based on a charge-coupled device camera (CCD Camera). However, the disadvantages of this method are as follows: 1. such measurement machines cannot automatically adjust the focus of the CCD camera, so they depend on experience of the user to a great extent; 2. such measurement machines need to measure the assemblies one by one, however, a large number of assemblies usually need to be measured to determine the machine performance in the practical SMT applications, therefore the measurement efficiency of such measurement machines is too low; 3. their size is too big to be used conveniently by users; and 4. such measurement machines are also relatively expensive.

### Contents of the invention

In order to solve the above-mentioned technical problems, the present invention provides a machine performance testing method, a machine performance testing device and a device for acquiring an image of a test sample, and the machine performance test in the SMT industry can be achieved with a relatively high efficiency and with relatively low costs by employing the method and device of the present invention.

A machine performance testing device according to the present invention comprises a transparent panel, a scanning device, and a computing device; whereby said transparent panel is used to acquire a test sample from a machine to be tested, wherein said test sample comprises at least one object placed on said transparent panel by said machine to be tested; said scanning device is used to scan said transparent panel to obtain image data; and said computing device is used to determine the operation accuracy of said machine to be tested according to the image data from said scanning device.

A machine performance testing method according to the present invention comprises: acquiring a test sample from a machine to be tested by using a transparent panel, wherein said test sample comprises at least one object placed on said transparent panel by said machine to be tested; scanning said transparent panel to obtain image data; and determining the operation accuracy of said machine to be tested according to said image data.

A device for acquiring an image of a test sample according to the present invention comprises the above-mentioned transparent panel and the above-mentioned scanning device.

The machine performance test in the SMT industry can be performed with a relatively high efficiency and with relatively low costs by employing the present invention.

### Brief description of the accompanying drawings

The above-mentioned and other features and advantages of the present invention will be made more apparent to those skilled in the art by the exemplary embodiments of the present invention described in detail below with reference to the accompanying drawings, in which:
Fig. 1 is a schematic diagram of a machine performance testing device according to an embodiment of the present invention;
Fig. 2 is a schematic diagram of the implementation principles of a device for acquiring an image of a test sample according to an embodiment of the present invention;
Fig. 3 is a flowchart of a machine performance testing method according to an embodiment of the present invention;
Fig. 4 is a schematic diagram of an example of the offset measured according to an embodiment of the present invention;
Fig. 5 is a flowchart of a method for testing the assembly accuracy of a placement machine according to an embodiment of the present invention;
Fig. 6 is a flowchart of a method for testing the offset of a printer according to an embodiment of the present invention; and
Fig. 7 is a flowchart of a method for testing the printing accuracy of a printer according to an embodiment of the present invention.

### Exemplary embodiments

Hereinbelow, the present invention will be further described in detail in conjunction with the accompanying drawings and embodiments. It should be understood that the particular embodiments described herein are only for the explanation of the present invention and are not to limit the present invention.

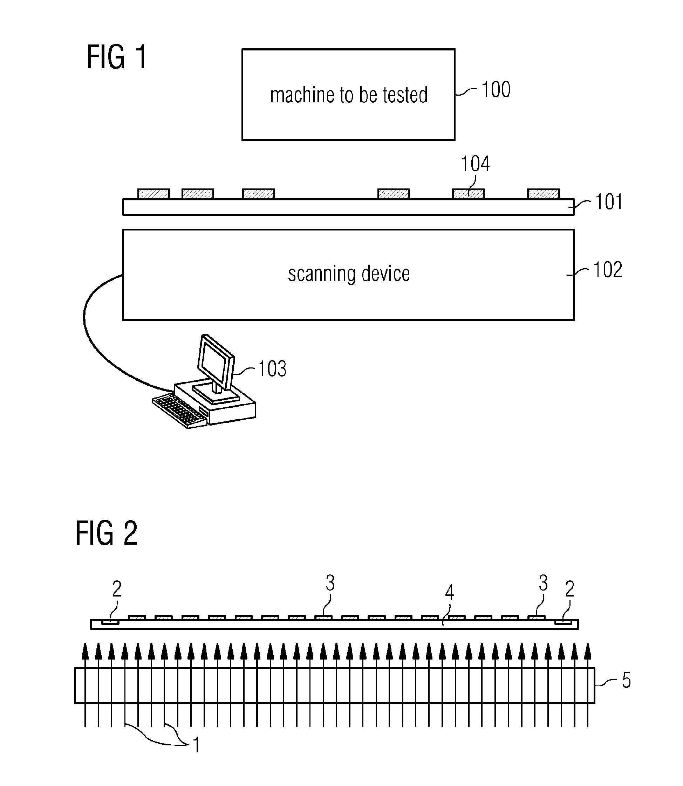

Fig. 1 is a schematic diagram of a machine performance testing device according to an embodiment of the present invention. As shown in Fig. 1, this machine performance testing device comprises a transparent panel 101, a scanning device 102 and a computing device 103, wherein:
the transparent panel 101 is used to acquire a test sample from a machine 100 to be tested. When testing the performance of a machine, the transparent panel 101 will be placed at a suitable position so that the machine 100 to be tested can put an object 104 handled by it on the transparent panel 101 (for example, a placement machine to be tested places an assembly on the transparent panel 101, or a printer to be tested prints a solder paste or glue on the transparent panel 101). Here, this embodiment of the present invention is suitable for an SMT machine (such as a placement machine or a printer, etc.), which SMT machine needs to place an object handled by it on a board in its normal operation, and when the SMT machine is tested according to the embodiment of the present invention, as for the SMT machine, the action with which it places the object 104 handled by it on the transparent panel 101 corresponds to a normal operation by it such as a placement or printing operation, so that a test sample is acquired on the transparent panel 101, which test sample comprises each object 104, such as an assembly, solder paste or glue, placed on the transparent panel 101 by the machine 100 to be tested and can indicate the position of the objects 104. Here, the transparent panel 101 can be a transparent glass panel or a transparent panel of other materials suitable for acquiring test samples from the SMT machine.

The scanning device 102 is used to scan the transparent panel 101 in order to obtain image data, wherein, since the test sample has been acquired on the transparent panel 101, apparently the image data obtained by the scan should be able to indicate the positional information of the objects 104 in the test sample. Here, the scanning device 102 can be various commonly-used scanners, or any scanning device that includes the core component (i.e., optical imaging component) of a currently available scanner. The implementation principles for the scanning device in obtaining the image data by scanning are not the contents concerned in the present invention, which will not be described in detail here.

The computing device 103 is used to determine the operation accuracy of the machine 100 to be tested according to the image data from the scanning device 102. In this case, the computing device 103 first simulates a current image of the transparent panel 101 according to the image data from the scanning device 102, computes the offset between the actual position and a respective ideal position of each object 104 in the test sample currently acquired on the transparent panel 101 according to the simulated image, and then determines the operation accuracy of the machine 100 to be tested according to the computed offset of each object 104. Here, such a computing device 103 can be any device capable of running certain software to complete the computation and/or statistical functions, for example, it can be implemented by employing a general-purpose personal computer (PC). Such a computing device 103 can be implemented as a hardware device, and it can also be a virtual device implemented by way of software.

In this case, in order to determine the offset of the actual position and the respective ideal position of each object 104 in the test sample, a series of data points can be set on the transparent panel 101 to establish a coordinate system to indicate the actual position of the object 104 on the transparent panel 101. In particular, two or three data points can be set on the transparent panel 101; preferably, these data points can be set on the corners of the transparent panel 101; for example, one data point can be set on each of two adjacent corners among the four corners of the transparent panel 101, or one data point can be set on each of three corners among the four corners of the transparent panel 101. In this case, those skilled in the art can know that the origin of a coordinate system can be determined according to several data points, so that the coordinate of the object 104 in this coordinate system can be determined according to the relative distance between the object 104 and the origin, thus this coordinate system can be used to represent the actual position of the object 104. Here, the same coordinate system is used to represent the actual position and the ideal position of the object 104, and then the offset can be determined according to the coordinate of the actual position and the coordinate of the predetermined ideal position.

Based on the machine performance testing device provided by the above-mentioned embodiment of the present invention, an embodiment of the present invention further provides a device for acquiring an image of a test sample from a machine to be tested, and the operation accuracy of the machine to be tested can be determined according to the image data of the test sample acquired by this device. This device for acquiring an image of a test sample at least includes: the transparent panel 101 and the scanning device 102 shown in Fig. 1.

Fig. 2 is a schematic diagram of the implementation principles of a device for acquiring an image of a test sample according to an embodiment of the present invention. As shown in Fig. 2, there are two data points 2 set on the front surface of the transparent panel 4 (setting the upward surface when the transparent panel 4 is horizontally placed as the front surface), and there are several objects 3 (such as an assembly or a solder paste). The scanning device is placed under the transparent panel 4, and when the scanning device is scanning, its scanning light source is stripe-shaped and radiates several lines of light rays 1 perpendicular to the transparent panel 4, and these light rays 1 radiate onto the reverse side of the transparent panel 4 and can scan the image information of the whole transparent panel 4 progressively, and the light rays 1 radiating onto the transparent panel 4 pass through a very narrow gap after having been reflected and then form a transverse beam 5. This beam 5 passes through a set of reflectors, is focused by a optical lens and goes into a spectroscope, passes through a prism and a three-color filter of red, green and blue to obtain three color beams of red, green and blue (RGB), with these three color beams respectively radiating onto its respective CCD, then the CCDs convert the RGB beams into analog electronic signals, and the analog electronic signals are converted into digital electronic signals by an analog/digital (A/D) converter. By then, the optical signals reflecting the image of the transparent panel 4 have been transformed into binary digital electronic signals. The digital electronic signals can be simulated to form an image of the transparent panel 4 after having been processed by the computing device. Here, since the embodiment of the present invention uses the transparent panel, the image of the transparent panel obtained by the scan can at the same time reflect the image of each object on the transparent panel, then this image can be used to determine the positional information of each object.

Based on the machine performance testing device provided by the above-mentioned embodiment of the present invention, an embodiment of the present invention further provides a machine performance testing method.

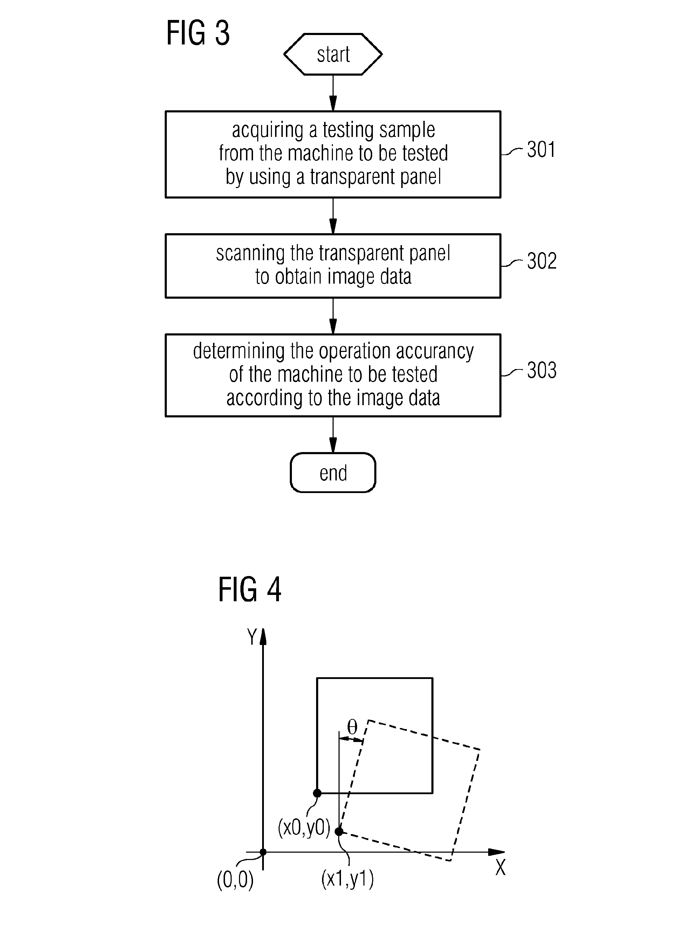

Fig. 3 is a flowchart of a machine performance testing method according to an embodiment of the present invention. In this embodiment, the method is applied to the device shown in Fig. 1. As shown in Fig. 3, this method comprises the following steps:
Step 301: a test sample is acquired from the machine 100 to be tested by using the transparent panel 101. Such a test sample includes the objects 104, such as an assembly or a solder paste, etc., placed on the transparent panel 101 by the machine 100 to be tested and can represent the position of each object 104.
Step 302: the transparent panel 101 is scanned by the scanning device 102 to obtain image data. In this case, the image data obtained by the scan can indicate the positional information of each object 104 in the test sample acquired on the transparent panel 101.
Step 303: the operation accuracy of the machine 100 to be tested is determined by the computing device 103 according to the image data from the scanning device 102. In this case, the computing device 103 first simulates a current image of the transparent panel 101 according to the image data from the scanning device 102, computes the offset between the actual position and the respective ideal position of each object 104 in the test sample currently acquired on the transparent panel 101 according to the simulated image, and then determines the operation accuracy of the machine 100 to be tested according to the computed offset of each object 104.

In this case, when computing the offset between the actual position and the respective ideal position of each object 104, the computed offset can include any one of the horizontal offset, the vertical offset, and the angle offset of the object 104, or any combination thereof. Preferably, the computed offset not only includes the offsets of the object 104 in the horizontal direction and the vertical direction but also includes the angle offset of the object 104. In particular, Fig. 4 is a schematic diagram of an example of the offset measured according to an embodiment of the present invention. As shown in Fig. 4, in the X-Y two dimensional coordinate system determined according to the data points, the ideal position of one certain point of a square object is (x0, y0), while in the test sample acquired on the transparent panel, the actual position of this point of this square object is (x1, y1). By comparing the coordinate of the ideal position of the square object and the coordinate of its actual position, the offset of the square object in the horizontal direction is determined to be x1 - x0, and its offset in the vertical direction be y1 - y0. At the same time, the angle offset of the square object can also be determined to be θ by comparing the image of the square object at the ideal position and the image at the actual position obtained by the scan. In this way, a user can obtain the operation accuracy of the machine expressed by the parameters (x, y, θ).

By employing the device and method provided by the above-mentioned embodiments of the present invention, a user can efficiently obtain the operation accuracy of an SMT machine. Generally, the test can be carried out according to the embodiments of the present invention while performing the daily maintenance to the SMT machine. The test results can be obtained in about half an hour and compared with the various existing testing techniques. The testing efficiency is improved significantly. In particular, when performing a test according to the embodiments of the present invention, the offsets of several objects on the transparent panel can be measured in one scan, while in the currently available technical solutions only one object's offset can be measured in one scan. In addition, the device and method provided by the embodiments of the present invention can also ensure the relatively high testing accuracy with low costs. In particular, the scanning device used in the embodiments of the present invention is based on the scanning technologies which have been known for a long time and are widely used now, and their resolutions are far higher than that of the CCD camera but the costs lower than that of the CCD camera, and this means that the testing accuracy of the embodiments of the present invention is far higher than the testing accuracy of the prior art employing the CCD camera and its implementation costs are very low. In addition, the embodiments of the present invention are relatively convenient in use, it is not necessary to adjust the focus or specific optical system of the scanning device during the test, and compared with the currently available testing devices, the testing device provided by the embodiments of the present invention is small in size and light in weight, and is very suitable for high frequency measurement.

Hereinbelow, the testing method provided by an embodiment of the present invention will be further described in further conjunction with practical application scenarios.

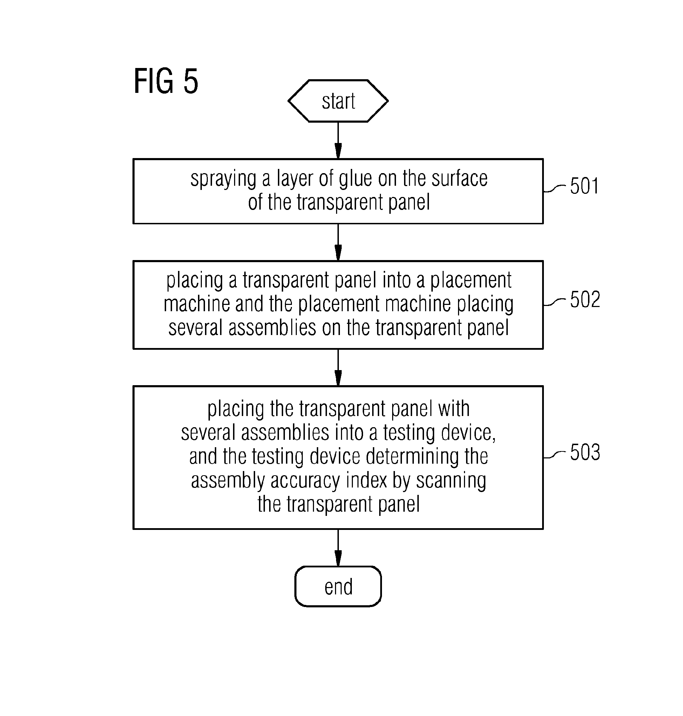

Fig. 5 is a flowchart of a method for testing the assembly accuracy of a placement machine according to an embodiment of the present invention. As shown in Fig. 5, this method comprises the following steps:
Step 501: a layer of glue is sprayed on the surface of a transparent panel.
Step 502: the transparent panel is placed into the placement machine, with the placement machine disposing several assemblies on the transparent panel.

In this case, when testing the performance of the placement machine, it is necessary to spray a layer of glue on the transparent panel to fix the assemblies, thus the position of the assemblies can be measured accurately.

After the above-mentioned steps 501 and 502, a test sample is acquired from the placement machine by using the transparent panel.

Step 503: the transparent panel with several assemblies is placed into a testing device according to the embodiment of the present invention, with this testing device determining the assembly accuracy index of the placement machine by scanning the transparent panel.

During the course of this method, as with the implementation principles of the previously mentioned testing device and method, the scanning device in this testing device first scans the transparent panel and outputs the image data to the computing device, and the computing device simulates a current image of the transparent panel according to this image data, computes the offset between the actual position and the respective ideal position of each assembly on the transparent panel according to the simulated image, and then determines the assembly accuracy index of the placement machine according to the offset of each assembly. Here, the offsets of a certain number of assemblies can be counted statistically to obtain the assembly accuracy index of the placement machine, and according to a practical application scenario, it can be set that only the offsets of a part of or all of the assemblies in the test sample currently acquired are counted statistically to obtain the assembly accuracy index, or it can also be set that the offsets of a part of or all of the assemblies in several test samples already acquired are counted statistically to obtain the assembly accuracy index; this assembly accuracy index may include: the complex process capability index (CPK) and/or process performance index (PPK), etc., and the particular computing method of the assembly accuracy index is not the subject concerned in the present invention, and will not be described in detail here.

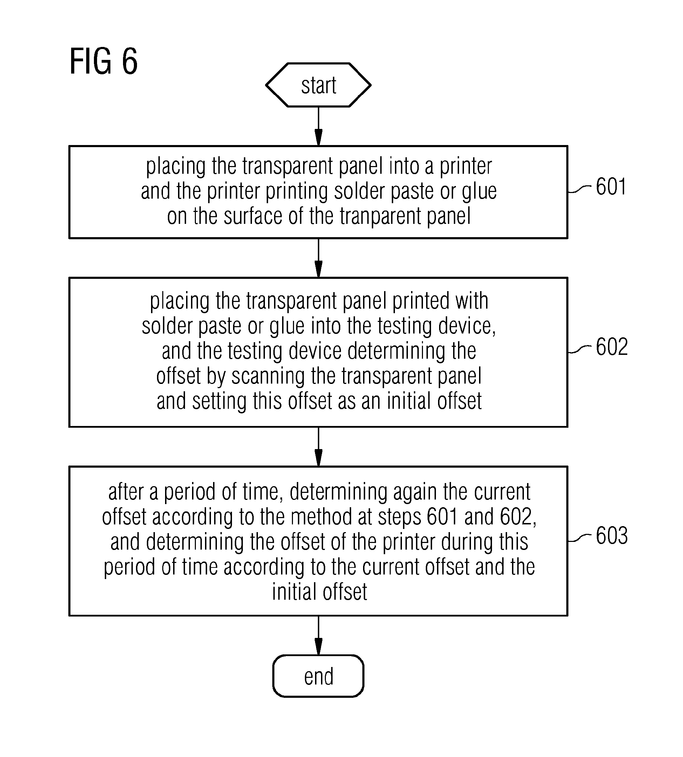

Fig. 6 is a flowchart of a method for testing the offset of a printer according to an embodiment of the present invention. As shown in Fig. 6, this method comprises the following steps:
Step 601: a transparent panel is placed into a printer, and a solder paste or glue is printed on the transparent panel using a template suitable for the transparent panel. Here, if glue is printed on the transparent panel, then the glue should possess a certain property so that the scanning device can scan the image of the printed glue when scanning the transparent panel.

After step 601, a test sample is acquired from the printer using the transparent panel.

Step 602: the transparent panel printed with the solder paste or glue is placed into the testing device according to the embodiment of the present invention, and the testing device determines the offset of the solder paste or glue printed at each place in the test sample acquired in step 601 by scanning the transparent panel and setting the offset as an initial offset.

During the course of this method, as with the implementation principles of the previously mentioned testing device and method, the scanning device in this testing device first scans the transparent panel and outputs the image data to the computing device, and the computing device simulates a current image of the transparent panel according to this image data and computes the offset of the actual position and the respective ideal position of the solder paste or glue printed at each place on the transparent panel according to the simulated image. Here, the ideal position of the solder paste or glue complies with the template for printing the solder paste or glue.

Step 603: after a period of time, the offset of the solder paste or glue printed at each place in the test sample currently acquired from the printer is again determined according to the method of steps 601 and 602, and then the amount of the misalignment of the printer during this period of time is determined according to the offset currently determined and the initial offset at step 602, i.e., the offset of the printer during this period of time.

In this case, the offset of the printer is generally measured by using the testing device provided by the embodiment of the present invention while performing the repair/maintenance operation, so that in the flow chart shown in Fig. 6, steps 601 and 602 can be performed during the initial repair/maintenance operation, and step 603 can be performed during a subsequent repair/maintenance operation, thus the offset of the printer can be determined between a certain repair/maintenance operation and the initial one, and the printer can be adjusted according to this offset, so that the printer can be restored to the state corresponding to the initial offset during the initial repair/maintenance operation.

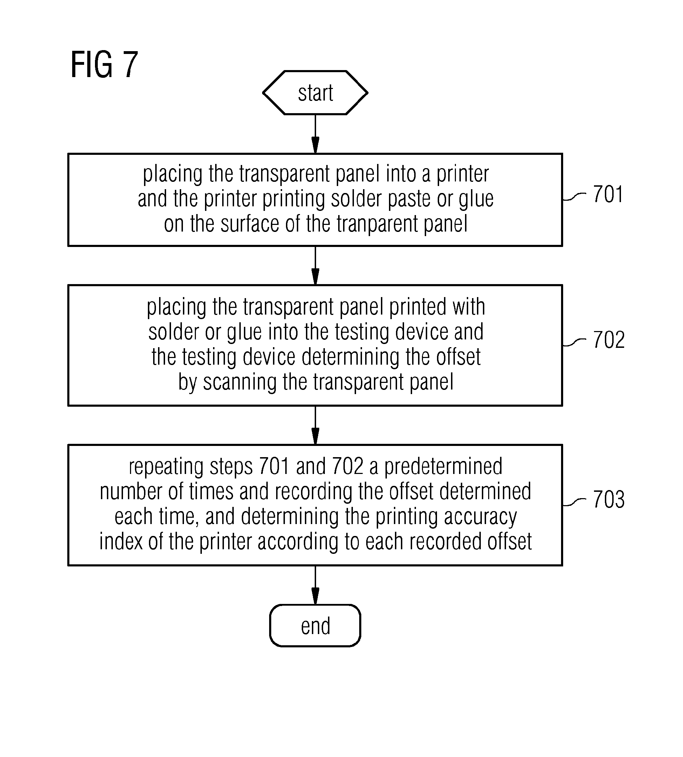

Fig. 7 is a flowchart of a method for testing the printing accuracy of a printer according to an embodiment of the present invention. As shown in Fig. 7, this method comprises the following steps:
Step 701: a transparent panel is placed into the printer, and solder paste or glue is printed on the transparent panel using a template suitable for the transparent panel.

After step 701, a test sample is acquired from the printer by using the transparent panel.

Step 702: the transparent panel printed with the solder paste or glue is placed into the testing device according to the embodiments of the present invention, and the testing device determines the offset of the solder paste or glue printed at each place in the test sample acquired at step 701 by scanning the transparent panel and recording each offset currently determined.

Here, the implementation principles of steps 701 and 702 are the same as those of the above-mentioned steps 601 and 602.

Step 703: steps 701 and 702 are repeated a predetermined number of times, for example, steps 701 and 702 are repeated twenty times, and the determined offset is recorded when steps 701 and 702 are performed each time. Finally, the printing accuracy index of the printer is determined according to each recorded offset. In this case, the method for determining the printing accuracy index according to each offset is the same as the method for determining the assembly accuracy index at step 503, which will not be described redundantly.

What are described above are only the preferred embodiments of the present invention and are not intended to limit the present invention, and any modification, equivalent, improvement, etc. made in the spirit and principles of the present invention shall be included in the protective scope of the present invention.

## Claims

1. A machine performance testing device, comprising a transparent panel (101, 4), a scanning device (102), and a computing device (103); wherein
said transparent panel (101, 4) is used for acquiring a test sample from a machine (100) to be tested; wherein said test sample comprises at least one object (104) placed on said transparent panel (101, 4) by said machine (100) to be tested;
said scanning device (102) is used for scanning said transparent panel to obtain image data; and,
said computing device (103) is used for determining the operation accuracy of said machine to be tested according to the image data from said scanning device (102).

2. The testing device according to claim 1, **characterized in that** said computing device (103) simulates an image of said transparent panel (101, 4) according to the image data from said scanning device (102), determines the offset between the actual position and a respective ideal position of each object (104) in the test sample currently acquired on said transparent panel (101, 4) according to the simulated image, and then determines the operation accuracy of said machine (100) to be tested according to the computed offset of each object (104).

3. The testing device according to claim 1, **characterized in that** when said machine (100) to be tested is a placement machine, the object (104) comprised in said test sample is an assembly placed on said transparent panel (101, 4); and when said machine to be tested is a printer, the object (104) comprised in said test sample is the solder paste or glue printed on said transparent panel (101, 4).

4. A machine performance testing method, comprising:
acquiring a test sample from a machine (100) to be tested by using a transparent panel (101, 4); wherein said test sample comprises at least one object (104) placed on said transparent panel (101, 4) by said machine to be tested;
scanning said transparent panel (101, 4) to obtain image data; and,
determining the operation accuracy of said machine (100) to be tested according to said image data.

5. The testing method according to claim 4, **characterized in that** said determining the operation accuracy of said machine to be tested according to said image data comprises:
simulating an image of said transparent panel (101, 4) according to said image data;
determining the offset between the actual position and a respective ideal position of each object (104) in the test sample currently acquired on said transparent panel (101, 4) according to said simulated image;
determining the operation accuracy of said machine to be tested according to said offset of each object (104).

6. The testing method according to claim 5, **characterized in that** said determining the operation accuracy of said machine (100) to be tested according to said offset of each object comprises:
determining said operation accuracy according to the offsets of a part of or all of the objects (104) in the test sample currently acquired; or
determining said operation accuracy according to the offsets of a part of or all of the objects (104) in a plurality of test samples already acquired.

7. The testing method according to claim 5 or 6, **characterized in that** said offset comprises any one of a horizontal offset, a vertical offset and an angle offset, or any combination thereof.

8. A machine performance testing method, said machine to be tested being a placement machine for the assembly accuracy of said placement machine to be tested;
said testing method comprising:
acquiring a test sample from the machine (100) to be tested by using a transparent panel (101, 4), wherein a layer of glue is sprayed on the surface of said transparent panel (101, 4), said transparent panel (101, 4) is placed into said placement machine, and at least one assembly is placed on said transparent panel (101, 4) by said placement machine;
scanning said transparent panel (101, 4) to obtain image data;
simulating an image of said transparent panel (101, 4) according to said image data;
determining the offset between the actual position and a respective ideal position of each assembly in the test sample currently acquired on said transparent panel (101, 4);
counting statistically the offsets of a part of or all of the assemblies in the test sample currently acquired, or counting statistically the offsets of a part of or all of the assemblies in a plurality of test samples already acquired, and computing the assembly accuracy of said placement machine so obtained.

9. A machine performance testing method, said machine to be tested being a printer, for the offset of said printer to be tested;
said testing method comprising:
during an initial stage, acquiring a test sample from said printer by using a transparent panel (101, 4), wherein said transparent panel is placed into said printer, and a solder paste or glue is printed on said transparent panel (101, 4) by using a template suitable for said transparent panel (101, 4); scanning said transparent panel (101, 4) to obtain image data; simulating an image of said transparent panel (101, 4) according to said image data; determining the offset between the actual position and a respective ideal position of the solder paste or glue printed at each place on said transparent panel (101, 4) according to the simulated image, and recording said offset as an initial offset; and
after a period of time, acquiring a test sample again from said printer by using said transparent panel (101, 4); scanning said transparent panel (101, 4) to obtain image data; simulating an image of said transparent panel (101, 4) according to said image data; determining the offset between the actual position and a respective ideal position of the solder paste or glue printed at each place on said transparent panel (101, 4) according to the simulated image, and comparing the offset currently obtained with said initial offset to obtain the offset of said printer during this period of time.

10. A machine performance testing method, said machine to be tested being a printer, for the printing accuracy of said printer to be tested;
said testing method comprising:
acquiring a test sample from said printer by using a transparent panel (101, 4), wherein said transparent panel (101, 4) is placed into said printer, and a solder paste or glue is printed on said transparent panel (101, 4) by using a template suitable for said transparent panel (101, 4); scanning said transparent panel (101, 4) to obtain image data; simulating an image of said transparent panel (101, 4) according to said image data; determining the offset between the actual position and a respective ideal position of the solder paste or glue printed at each place on said transparent panel (101, 4) according to the simulated image, and recording said offset;
repeating the above steps a predetermined number of times; and
counting statistically each of the offsets recorded, and computing the printing accuracy of said printer.

11. A device for acquiring an image of a test sample, **characterized in that** it comprises a transparent panel (101, 4) and a scanning device (102); wherein:
said transparent panel (101, 4) is used for acquiring a test sample from a machine (100) to be tested; wherein said test sample comprises at least one object (104) placed on said transparent panel (101, 4) by said machine (100) to be tested; and
said scanning device (102) is used for scanning said transparent panel (101, 4) to obtain image data.
